# EUROPEAN PATENT APPLICATION

(11) **EP 2 770 252 A1**
(43) Date of publication of application: **27.08.2014**
(21) Application number: 12842560.0
(22) Date of filing: 05.07.2012
(51) Int. Cl.: F21V 9/10, F21S 2/00

(54) **LED COLOR CONVERSION FILTER, METHOD OF MANUFACTURING SAME, AND LED MODULE INCLUDING SAME**

(30) Priority: 17.10.2011 KR 20110106033
(71) Applicant: Cho, Shim Hyun, Seodaemun-gu, Seoul 120-121 (KR); Hyun, Byeong Moon, Gwangju-si, Gyeonggi-do 464-924 (KR)
(72) Inventor: Cho, Shim Hyun, Seodaemun-gu, Seoul 120-121 (KR); Hyun, Byeong Moon, Gwangju-si, Gyeonggi-do 464-924 (KR)
(74) Representative: v. Bezold & Partner Patentanwälte - PartG mbB
(86) International application number: PCT/KR2012/005350
(87) International publication number: WO 2013/058467

(57) **Abstract**

The present invention relates to an LED color conversion filter and an LED module including same. Provided are an LED color conversion filter having a light-transmitting inclination of 0.2 degrees to 0.7 degrees in an LED emitting light region of 420 nm to 500 nm, and an LED module including same.

## Description

### Technical Field

The present invention relates to a light-emitting diode color conversion filter, a preparation method thereof and a light-emitting diode module comprising the same, and more particularly to a light-emitting diode color conversion filter, which can transmit light having a wavelength of 500 nm or more and selectively block the transmission of blue light in the wavelength range of 400-500 nm to enable changes in the color temperature and color rendering index of a light-emitting diode while minimizing a decrease in total brightness, and a preparation method thereof and a light-emitting diode module comprising the same.

### Background Art

In light-emitting diode (LED) lighting devices, the color temperature, color rendering and power efficiency of the LED are determined by the light emitted from the LED that emits white light. LEDs that are generally used for lighting include pure white LEDs that emit light having a color temperature between 5,000 K and 8,000 K, natural white LEDs having a color temperature between 3,500 K and 4,500 K, and warm white LEDs having a color temperature between 2,500 K and 3,500 K. Such LEDs are generally realized by combining YAG phosphors with LEDs that emit blue light in the wavelength range of 450-480 nm. Such LEDs have the highest peak power in the blue wavelength range of 450 nm to 480 nm and have the next higher peak power in the green wavelength range of 520 nm to 580 nm and in the red wavelength range of 610 nm to 680 nm in that order. Because phosphors generally function to convert blue light to green light or red light, the power density of LEDs is the highest for pure white LEDs and the lowest for warm white LEDs. Generally, natural white LEDs have a light power of about 85% of that of pure white LEDs, and warm white LEDs have a power efficiency of about 75% of that of pure white LEDs.

Meanwhile, when the concentration of phosphors is controlled to increase the amount of light in the red wavelength range in order to increase the color rendering index that indicates the color reproduction fidelity of a light source, the power efficiency of the light source may be reduced. In general, in order to achieve a color rending index of 85-95 or more in warm white LEDs, the concentration of phosphors in the LEDs should be sufficiently controlled to the maximize the emission of light in the red wavelength range. In this case, the power efficiency will be reduced by about 10-15% compared to that of warm white LEDs having a color rendering index of 70-80 or natural white LEDs.

In the case of conventional LED lighting devices, in order to selectively achieve various color temperatures, including pure white, natural white and warm white, three types of LED arrays (i.e., pure white, natural white and warm white LED arrays) are placed in an LED lamp. In this case, when the user requires the pure white LED, the natural white LED and the warm white LED are switched off, and when the natural white LED is required, the pure white LED and the warm white LED are switched off, and when the warm white LED is required, the pure white LED and the natural white LED are switched off. However, in this case, there is a problem in that the number of LEDs used in the lighting device is three times larger than that of LEDs in a lighting device that emits single-color light, suggesting that the lighting device is highly expensive. In addition, when high-pass filters are used in an LED to reduce the amount of light in the blue wavelength range and relatively increase the amount of light in the red wavelength range in order to achieve a high color rendering index and a selective color temperature in the LED, there is a problem in that not only the amount of light in the blue wavelength range (420-480 nm), but also the amount of light in the green wavelength range (500-550 nm), which represents the largest portion of the total amount of light, decreases, resulting in a decrease in the power efficiency of the lighting device.

### Disclosure

### Technical Problem

Accordingly, the present invention has been made in order to solve the above-described problems occurring in the prior art, and an object of the present invention is to provide a light-emitting diode color conversion filter, which transmit light having a wavelength of 500 nm or more and selectively block the transmission of blue light in the wavelength range of 400-500 nm to enable changes in the color temperature and color rendering index of a light-emitting diode while minimizing a decrease in total brightness, and a preparation method thereof and a light-emitting diode module comprising the same.

### Technical Solution

In accordance with exemplary embodiments of the present invention, there is provided a light-emitting diode color conversion filter having a slope of light transmittance of 0.2-0.7 in the wavelength range of 420-500 nm for light emitted from a light-emitting diode.

In accordance with another aspect of the present invention, there is provided a light-emitting diode module comprising: a plurality of light-emitting diodes mounted on a printed circuit board so as to be spaced from each other; and a light-emitting diode color conversion filter according to the above embodiments, wherein the plurality of light-emitting diodes include a first light-emitting diode having a color temperature corresponding to any coordinates located in a region defined by the following six coordinates of the CIE 1931 standard colorimetric system, and a second light-emitting diode that emits red light: (0.28, 0.28), (0.40, 0.33), (0.42, 0.36), (0.44, 0.42), (0.36, 0.43), and (0.28, 0.34).

In accordance with still another aspect of the present invention, there is provided a method for preparing a light-emitting diode color conversion filter, the method comprising the steps of: (a) irradiating a photopolymerizable composition, comprising 97-99.8 wt% of an urethane acrylate oligomer and 0.2-3 wt% of a photopolymerization initiator, with 500-5000 mJ/cm² of UV light to cure the composition; and (b) heat-treating the cured composition, wherein the urethane acrylate oligomer has an urethane bond in the main chain an contains 2-12 acrylate functional groups.

In accordance with still another aspect of the present invention, there is provided a light-emitting diode color conversion filter which is prepared according to the above-described method and selectively blocks light having a wavelength shorter than 500 nm.

In accordance with still another aspect of the present invention, there is provided a light-emitting diode module comprising: a light source unit comprising one or more pure white LEDs that emit pure white color having a color temperature ranging from 5000 K to 8000 K; and a light-emitting diode conversion filter configured to block a portion of the wavelength range of light emitted from the pure white LEDs to convert the color of the light.

### Advantageous Effects

According to the present invention, there may be provided a light-emitting diode color conversion filter, which transmits light having a wavelength of 500 nm or more and selectively blocks the transmission of blue light in the wavelength range of 400-500 nm to enable changes in the color temperature and color rendering index of the light-emitting diode while minimizing a decrease in total brightness.

In addition, the light-emitting diode color conversion filter prepared by the method of the present invention functions as a high-pass filter that can transmit green light having a wavelength of 500 nm or longer and selectively block light having a wavelength shorter than 500 nm. Thus, when a light-emitting diode module comprises the light-emitting diode color conversion filter of the present invention, a decrease in the emission of green light does not occur, and thus a decrease in the total brightness of a lighting lame can be minimized. Particularly, a light-emitting diode module comprising the light-emitting diode color conversion filter of the present invention can emit warm-white light while maintaining the highest power efficiency, or can selectively emit pure white light, natural white light and warm-white light using only pure white LEDs and red LEDs. In particular, there is little or no decrease in the color rendition when emitting warm-white light arises, and this a color rendering index of 85 or more can be maintained.

### Description of Drawings

FIG. 1 is a graphic diagram showing the transmittance of a light-emitting diode color conversion filter according to the present invention as a function of wavelength.
FIG. 2 is a table showing the slope of the light transmittance of a light-emitting diode color conversion filter.
FIG. 3a is a spectral transmission curve of a light-emitting diode (LED) color conversion filter according to a first embodiment of the present invention; and FIG. 3b shows a spectral curve of an LED having a color temperature of 6500 K and a spectral curve of an LED comprising a color conversion filter having the spectral transmission characteristics of FIG. 3a.
FIG. 4 shows the CIE coordinates of an LED having a color temperature of 6500 K and the CIE coordinates of an LED comprising a color conversion filter and having a color temperature of 5800 K.
FIG. 5a is a spectral transmission curve of a light-emitting diode (LED) color conversion filter according to a second embodiment; and FIG. 5b shows a spectral curve of an LED having a color temperature of 6800 K and a spectral curve of an LED comprising a color conversion filter having the spectral transmission characteristics of FIG. 5a.
FIG. 6 shows the CIE coordinates of an LED having a color temperature of 6800 K and the CIE coordinates of an LED comprising a color conversion filter and having a color temperature of 5300 K.
FIG. 7a is a spectral curve of an LED having a color temperature of 4200 K; FIG. 7b is a spectral curve of a red-wavelength LED; FIG. 7c is a spectral transmission curve of a light-emitting diode (LED) color conversion filter; and FIG. 7d is a spectral curve of a light-emitting diode module comprising a combination of an LED having a color temperature of 4200 K, a red-wavelength LED and an LED color conversion filter.
FIG. 8 shows the CIE coordinates of the LED shown in FIG. 7.
FIG. 9 is a schematic view showing the structure of a light-emitting diode module according to a third embodiment of the present invention.
FIG. 10 is a schematic view showing the structure of a light-emitting diode module according to a fourth embodiment of the present invention.
FIG. 11 is a schematic top view of a light-emitting diode color conversion filter used in the embodiment of FIG. 10.
FIG. 12 shows an alternative embodiment of the light-emitting diode module shown in FIG. 10.
FIG. 13 shows a color temperature region in the CIE 1931 color coordinates, which is related to lighting lamps.
FIG. 14 is a schematic view showing the structure of a light-emitting diode module according to a fifth embodiment of the present invention.
FIGS. 15 and 16 show the operation of the light-emitting diode module shown in FIG. 14.
FIG. 17 is a functional block diagram of a light-emitting diode lighting device comprising a light-emitting diode module according to the present invention.
FIG. 18 shows the UV/Vis transmission spectrum distribution for the light-emitting diode color conversion filters prepared according to sixth to ninth embodiments of the present invention.
FIG. 19 shows the emission spectrum distribution of a pure white LED; FIG. 20 shows the emission spectrum distribution of a natural white LED; and FIG. 21 shows the emission spectrum distribution of a warm-white LED.
FIG. 22 shows the configuration of a light-emitting diode module according to a tenth embodiment of the present invention; and FIG. 23 shows the spectral distribution of light in a process in which pure white light is converted to natural white light by the light-emitting diode module shown in FIG. 22.
FIG. 24 shows the configuration of a light-emitting diode module according to an eleventh embodiment of the present invention; and FIG. 25 shows the spectral distribution of light in a process in which the pure white light and red light emitted from the light source unit are converted to warm-white light by the light-emitting diode module shown in FIG. 24.
FIG. 26 shows the configuration of a light-emitting diode lighting device according to a twelfth embodiment of the present invention; and FIG. 27 shows the spectral distribution of light in a process in which the natural white light emitted from the light source unit is converted to warm-white light by the light-emitting diode lighting device shown in FIG. 26.
FIG. 28 shows the configuration of a light-emitting diode lighting device according to a thirteen embodiment of the present invention; and FIG. 29 shows the spectral distribution of light in a process in which the natural white light and red light emitted from the light source unit is converted to warm-white light by the light-emitting diode lighting device shown in FIG. 28.

### Mode for Invention

Hereinafter, preferred embodiments of the present invention will be described in detail with reference to the accompanying drawings.

### Process for preparing a light-emitting diode color conversion filter

Step 1: 0.0001-0.06 wt% of a dye or pigment that absorbs light at a wavelength of 500 nm or less is mixed with a thermosetting or photocurable resin or a thermoplastic resin.

Step 2: the mixture of step 1 is formed into a plate.

In this embodiment, examples of the dye that absorbs light at a wavelength of 500 nm include acetate dyes, anthraquinone dyes, and azo dyes, and examples of the pigment that absorbs light at a wavelength of 500 nm include inorganic pigments such as lead chromate, iron oxide yellow, cadmium and titanium pigments, azo pigments and phthalocyanine pigments.

Specifically, as the dye, an acetate dye, an anthraquinone dye or an azo dye is used, and as the pigment, a nitro pigment, an azo pigment or an indanthrene pigment is used.

Also, examples of the thermosetting or photocurable resin that is used in the present invention include acrylate resin and epoxy resin, and examples of the thermoplastic resin that is used in the present invention include polycarbonate and polymethylmethacrylate (PMMA).

### Equation 1

Slope of light transmittance = (light transmittance at wavelength A - light transmittance at wavelength B) / (wavelength A - wavelength B)

Equation 1 above indicates a method of calculating the inclination of light transmittance in a specific wavelength range, and the LED color conversion filter manufactured according to the above-described process has an inclination of light transmittance of 0.2-0.7.

The LED color conversion filter according to the present invention has an inclination of light transmittance of 0.2-0.7 in the wavelength range of 420-500 nm so that a decrease in the emission of green light from the LED can be minimized while the emission of blue light is limited, thereby inducing changes in the color temperature and color rendering index of the LED.

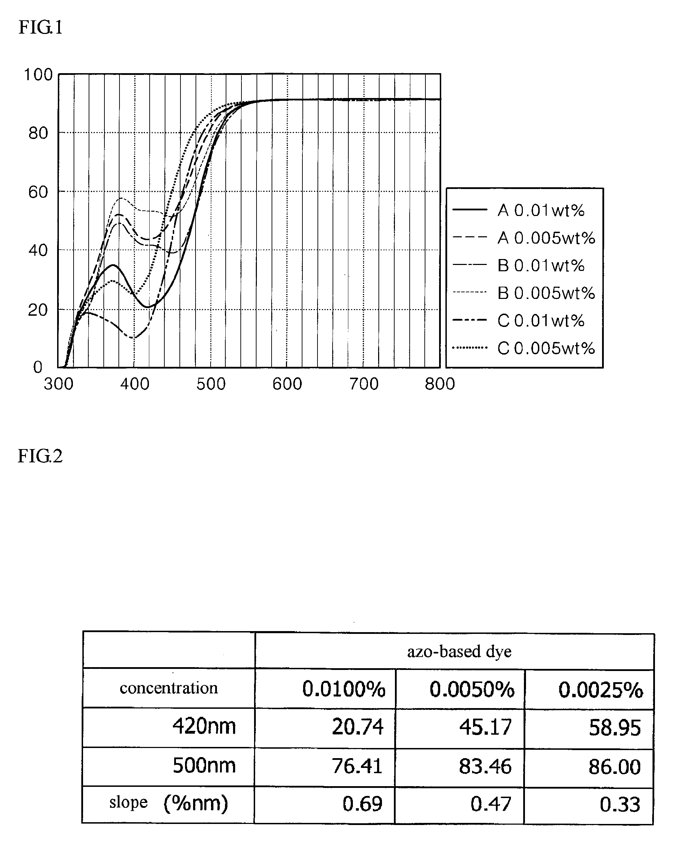

FIG. 1 is a graphic diagram showing the transmittance of a light-emitting diode color conversion filter according to the present invention as a function of wavelength, and FIG. 2 is a table showing the slope of the light transmittance of a light-emitting diode color conversion filter.

FIG. 1 shows spectral transmission curves of LED color conversion filters manufactured using various azo dyes. FIG. 2 shows the slopes of light transmittance at 420 nm, light transmittance at 500 nm and light transmittance in the range of 420-500 nm as a function of changes in the content of azo dye. As can be seen in FIG. 2, the light transmittance at 420 nm 20.74% at an azo dye content of 0.01 wt%, 45.17% at an azo dye content of 0.005 wt%, and 58.95% at an azo dye content of 0.0025 wt%. The light transmittance at 500 nm is 76.41% at an azo dye content of 0.01 wt%, 83.46% at an azo dye content of 0.005 wt%, and 86% at an azo dye content of 0.0025 wt%. The slope of the light transmittance is 0.69 at an azo dye content of 0.01 wt%, 0.47 at an azo dye content of 0.005 wt%, and 0.33 at an azo dye content of 0.0025 wt%.

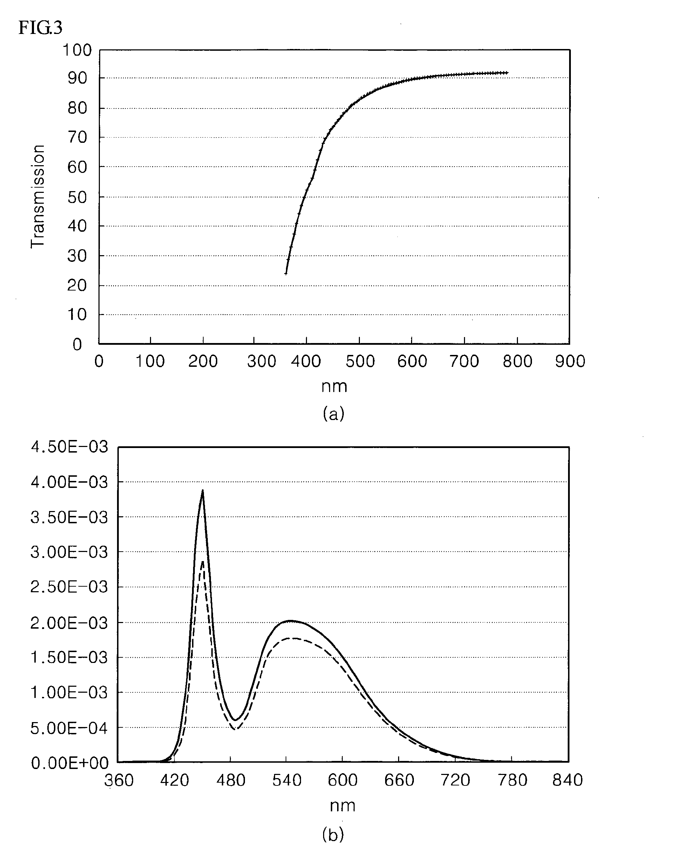

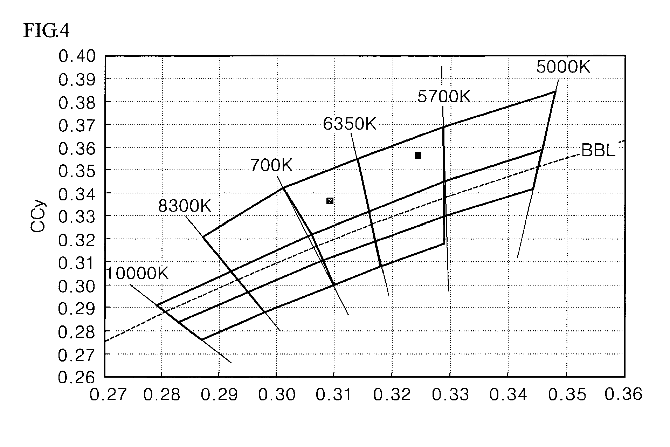

FIG. 3a is a spectral transmission curve of a light-emitting diode color conversion filter according to a first embodiment of the present invention; FIG. 3b shows a spectral curve of an LED having a color temperature of 6500 K and a spectral curve of an LED comprising a color conversion filter having the spectral transmission characteristics of FIG. 3a; and FIG. 4 shows the CIE coordinates of an LED having a color temperature of 6500 K and the CIE coordinates of an LED comprising a color conversion filter and having a color temperature of 5800 K.

With respect to FIGS. 3a, 3b and 4, an LED color conversion filter having a slope of light transmittance of 0.38 is used in this embodiment. FIG. 3a shows a spectral transmission curve of the LED color conversion filter having a slope of light transmittance of 0.38; the upper curve in FIG. 3b is a spectral curve of an LED having a color temperature of 6500 K; and the lower curve in FIG. 3c is a spectral curve of an LED having a color temperature of 5800 K as a result of combining an LED having a color temperature of 6500 K with an LED color conversion filter having a slope of light transmittance of 0.38. When the LED color conversion filter having a slope of light transmittance of 0.38 as described in this embodiment is used, an LED having a color temperature of 6500 K can be converted to an LED having a color temperature of 5800 K without having to use other additional LED.

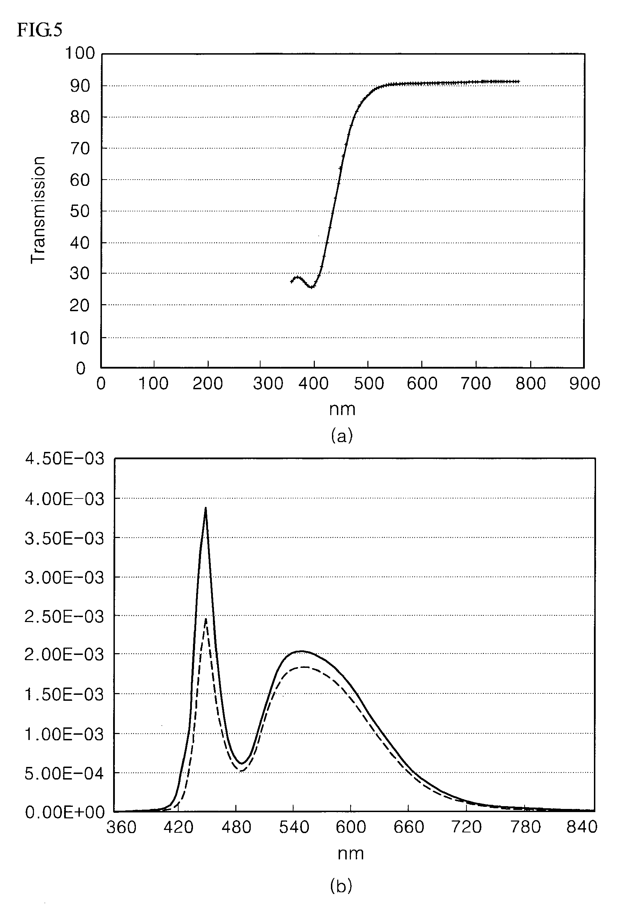

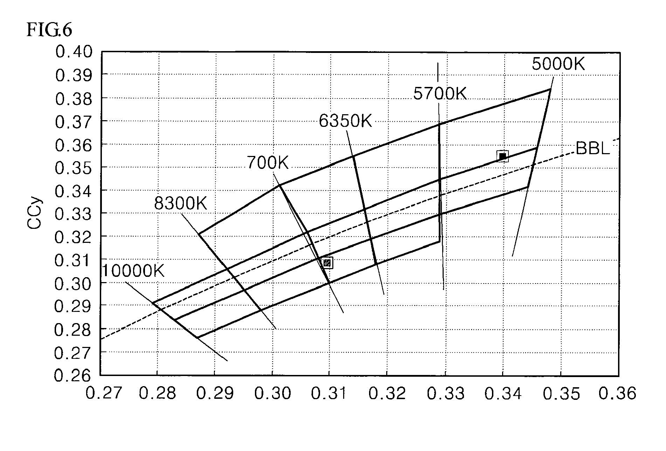

FIG. 5a is a spectral transmission curve of a light-emitting diode color conversion filter according to a second embodiment; FIG. 5b shows a spectral curve of an LED having a color temperature of 6800 K and a spectral curve of an LED comprising a color conversion filter having the spectral transmission characteristics of FIG. 5a; and FIG. 6 shows the CIE coordinates of an LED having a color temperature of 6800 K and the CIE coordinates of an LED comprising a color conversion filter and having a color temperature of 5300 K.

Referring to FIGS. 5a, 5b and 6, in this embodiment, an LED color conversion filter having a slope of light transmittance of 0.64 is used. FIG. 5a shows a spectral transmission curve of an LED color conversion filter having a slope of light transmittance of 0.64; the upper curve in FIG. 5b is a spectral curve of an LED having a color temperature of 6800 K; and the lower curve in FIG. 5b is a spectral curve of an LED having a color temperature of 5300 K as a result of combining an LED having a color temperature of 6800 K with an LED color conversion filter having a slope of light transmittance of 0.64. When the LED color conversion filter having a slope of light transmittance of 0.64 is used as described in this embodiment, an LED having a color temperature of 6800 K can be converted to an LED having a color temperature of 5300 K without having to use other additional LED.

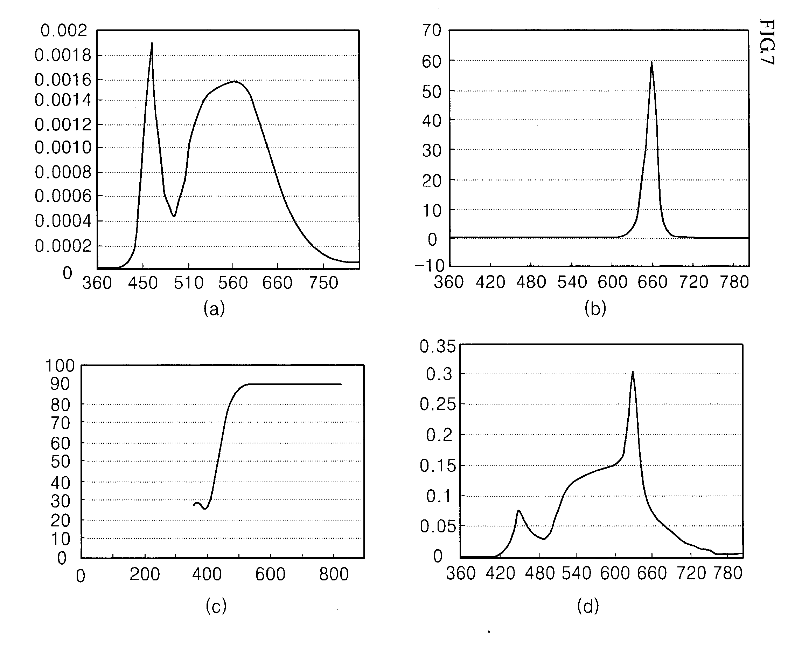

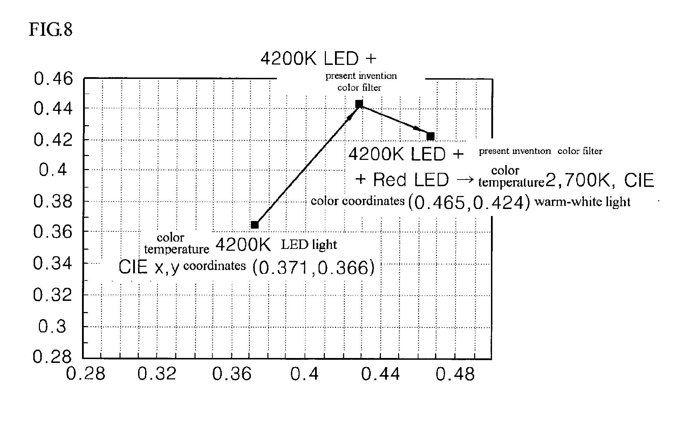

FIG. 7a is a spectral curve of an LED having a color temperature of 4200 K; FIG. 7b is a spectral curve of a red-wavelength LED; FIG. 7c is a spectral transmission curve of a light-emitting diode color conversion filter; FIG. 7d is a spectral curve of a light-emitting diode module comprising a combination of an LED having a color temperature of 4200 K, a red-wavelength LED and a light-emitting diode color conversion filter; and FIG. 8 shows the CIE coordinates of the LED shown in FIG. 7.

Referring to FIGS. 7a to 7d and 8, in this embodiment, an LED color conversion filter having a slope of light transmittance of 0.64 is used. FIG. 7a is a spectral curve of a white LED having a color temperature of 4200 K; FIG. 7b is a spectral curve of a red LED; and FIG. 7c is a spectral transmission curve of an LED color conversion filter having a slope of light transmittance of 0.64. A combination of the white LED, the red LED and the LED conversion filter having a slope of light transmittance of 0.64 can provide an LED having a color temperature of 2700 K.

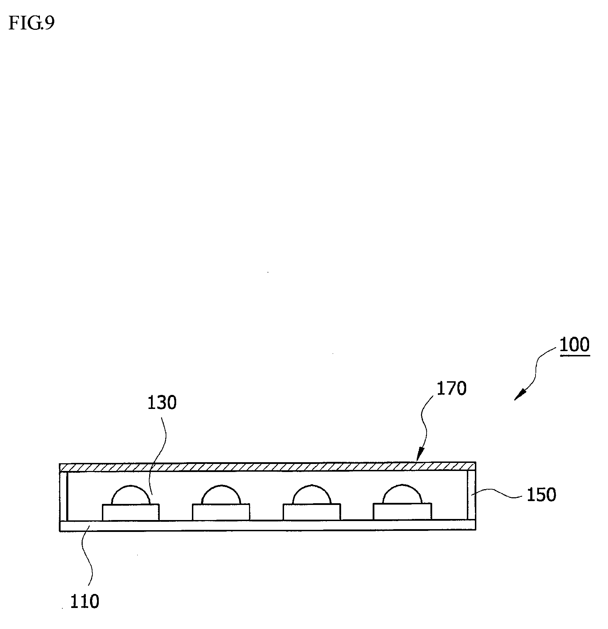

FIG. 9 is a schematic view showing the structure of a light-emitting diode module according to a third embodiment of the present invention. Referring to FIG. 9, a light-emitting diode module 100 comprises a printed circuit board 110, a plurality of light-emitting diodes 130, a support member 150 and an LED color conversion filter 170. The plurality of light-emitting diodes 130 are mounted on the printed circuit board 110 so as to be spaced from each other. Each of the light-emitting diodes mounted on the printed circuit board is composed of a light-emitting chip, a lead frame, a wire, a molding portion and a substrate. Specifically, the lead frame is disposed on the substrate, and the light-emitting chip is mounted on the substrate and is electrically connected to the lead frame by the wire. The molding portion encapsulates the light-emitting chip on the substrate to protect the light-emitting chip and serves to adjust the angle of light that is emitted from the light-emitting chip. The support member 150 is placed on the printed circuit board 110, serves to support the LED color conversion filter 170 and is disposed spaced from the light-emitting diodes 130. The light-emitting diode color conversion filter 170 has a slope of light transmittance of 0.2-0.7 in the wavelength range of 420-500 nm. As a result, in the light-emitting diode module according to the present invention according to this embodiment, a decrease in the emission of green light from the LED can be minimized while the emission of blue light can be limited, thereby inducing changes in the color temperature and color rendering index of the LED. The LED color conversion filter 170 can be integrated with a light diffusion plate or a light diffusion pattern using a method such as coating or bonding.

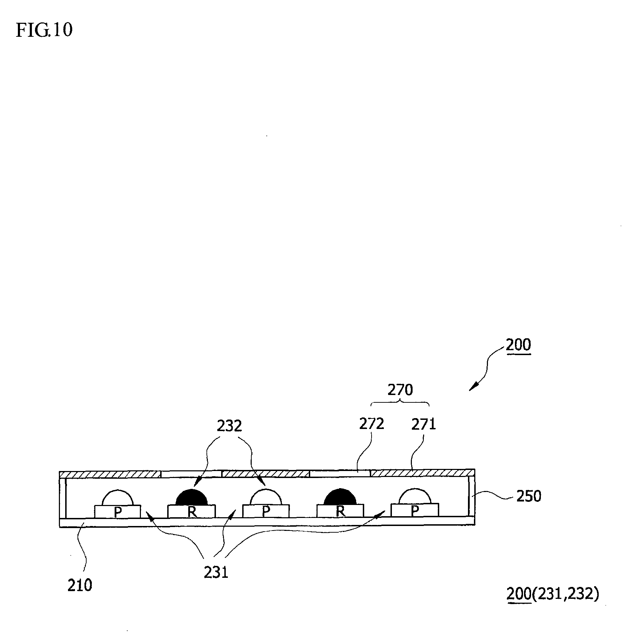

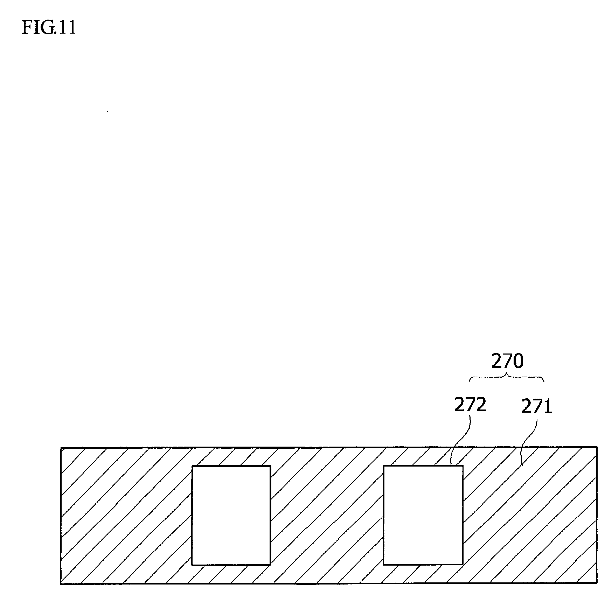

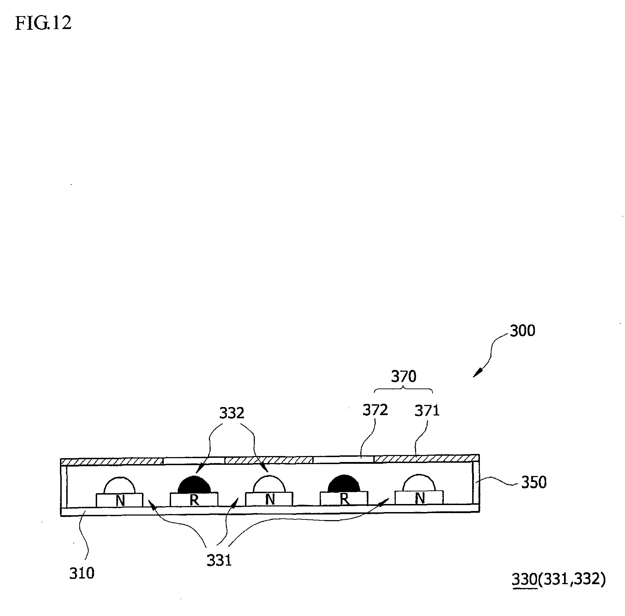

FIG. 10 is a schematic view showing the structure of a light-emitting diode module according to a fourth embodiment of the present invention; FIG. 11 is a schematic top view of a color conversion filter for a light-emitting diode, used in the embodiment of FIG. 10; and FIG. 12 shows an alternative embodiment of the light-emitting diode module shown in FIG. 10.

Referring to FIGS. 10 and 11, a light-emitting diode module 200 according to this embodiment comprises a printed circuit board 210, a plurality of light-emitting diodes 230, a support member 250, a light-emitting diode color conversion filter 270 and a control unit (not shown). The plurality of light-emitting diodes 230 are mounted on the printed circuit board 210 so as to be spaced from each other. The light-emitting diodes 230 include a first light-emitting diode 231 and a second light-emitting diode 232. The first light-emitting diode 231 is a pure white light-emitting diode having a color temperature of 5000 K, and the second light-emitting diode 232 is a red light-emitting diode. The first light-emitting diodes 231 and the second light-emitting diodes 232 are alternately disposed on the printed circuit board 210. The support member 250 is placed on the printed circuit board 210, supports the LED color conversion filter 270 and is disposed spaced from the LED diodes 230. The LED color conversion filter 270 includes color filter regions 271 and transmission regions 272, which are alternately disposed. The color filter regions 271 are positioned above the first light-emitting diodes 231, and the transmission regions 272 are positioned above the second light-emitting diodes 232. Also, the color filter regions 271 of the light-emitting diode color conversion filter 270 are formed to have a slope of light transmittance of 0.2-0.7 in the wavelength range of 420-500 nm. The control unit (not shown) serves to control the ON/OFF operation of the first light-emitting diodes (231) and the second light-emitting diodes (232). Meanwhile, the first light-emitting diode 231 and the second light-emitting diode 232 have different deterioration rates, and thus show a difference in light-emitting efficiency with the passage of time. The control unit compensates for the difference in light emission caused by difference in deterioration rate between the first light-emitting diode 231 and the second light-emitting diode 232 by controlling the amount of current that is supplied to each light-emitting diode. If the control unit operates only the first light-emitting diode 231 having a pure white color temperature of 5000 K without operating the second light-emitting diode 232 that emits red light, the light emitted from the light-emitting diode module 200 is converted to natural white light having a color temperature of 4200 K. Also, if the control unit operates both the first light-emitting diode 231 having a pure white color temperature of 5000 K and the second light-emitting diode 232 that emits red light, the light emitted from the light-emitting diode module 200 is converted to warm white light having a color temperature of 3000 K. FIG. 12 shows an alternative embodiment of the light-emitting diode module shown in FIG. 10. As shown in FIG. 12, the light-emitting diode module 300 comprises first light-emitting diodes 331 and second light-emitting diodes 332. The first light-emitting diode 331 is a pure white light-emitting diode having a color temperature of 4500 K, and the second light-emitting diode 332 is a red light-emitting diode. If both the first light-emitting diode 331 having a pure white temperature of 4500 K and the second light-emitting diode 332 that emits red light are operated, the light emitted from the light-emitting diode module 300 is converted to warm white light having a color temperature of 2700 K.

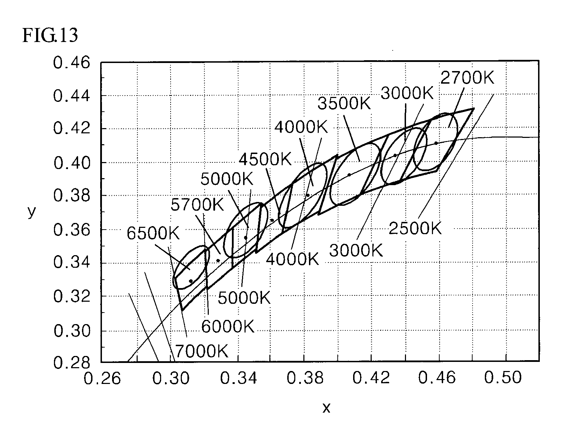

FIG. 13 shows a color temperature region in the CIE 1931 color coordinates, which is related to lighting lamps. The color temperatures of the first light-emitting diodes of the light-emitting diode modules shown in FIGS. 10 to 12 have been given by way of example and are not restrictive. The first light-emitting diode that is used in the present invention may be a white light-emitting diode having a color temperature corresponding to any coordinates in a region defined by the following six coordinates in the CIE 1931 color coordinates shown in FIG. 13. Specifically, the white light-emitting diode that is used as the first light-emitting diode in the embodiments of the present invention has any color coordinates located in a region defined by the following six color coordinates: (0.28, 0.28), (0.40, 0.33), (0.42, 0.36), (0.44, 0.42), and (0.36, 0.43).

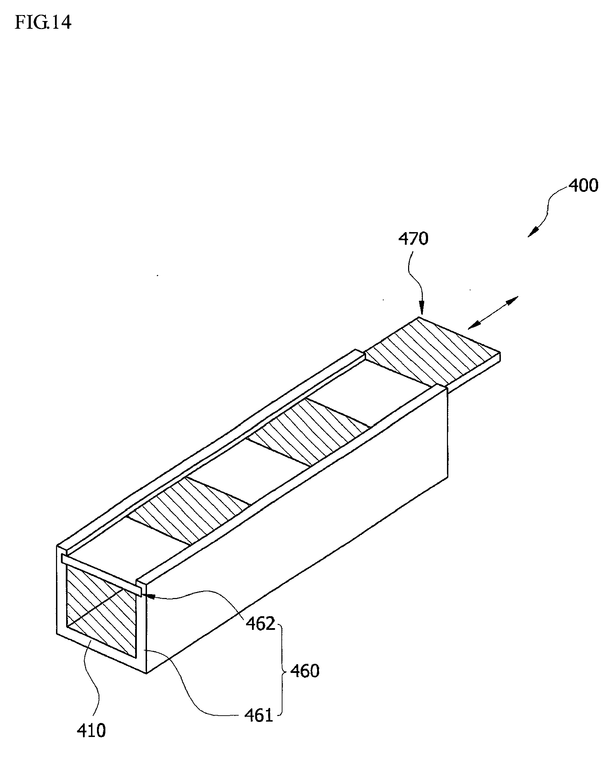

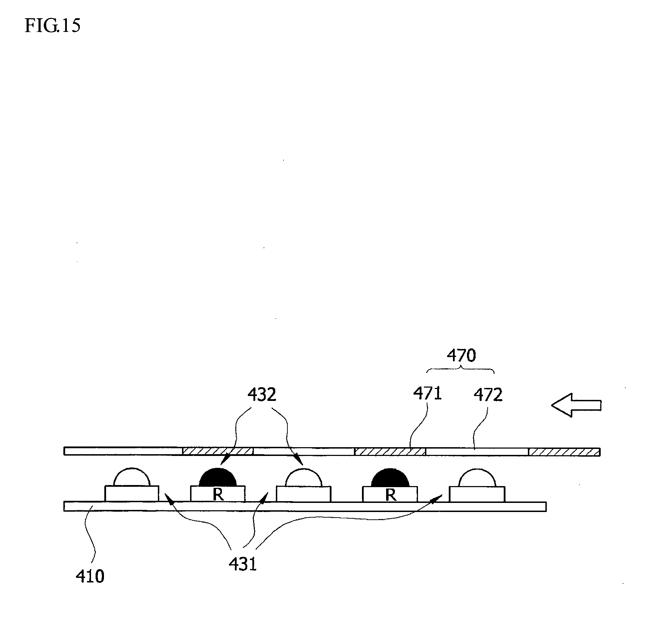

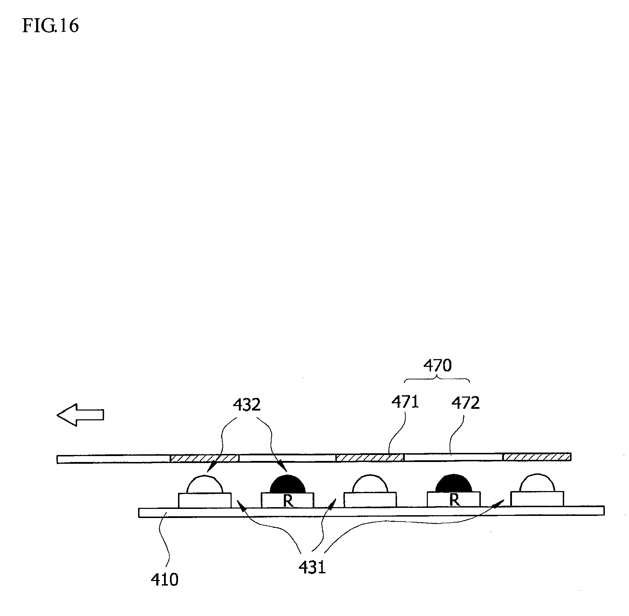

FIG. 14 is a schematic view showing the structure of a light-emitting diode module according to a fifth embodiment of the present invention; and FIGS. 15 and 16 show the operation of the light-emitting diode module shown in FIG. 14. This embodiment differs from the above-described embodiments in that the position of the light-emitting diode color conversion filter is movable, and the remaining construction is similar between the elements. Thus, the difference will be mainly described hereinafter. Referring to FIGS. 14 to 16, a light-emitting diode module 400 according to this embodiment comprises a printed circuit board 410, a plurality of light-emitting diodes 430, a guide member 460 and a light-emitting diode color conversion filter 470. The plurality of light-emitting diode 430 are mounted on the printed circuit board 410 so as to be spaced from each other. The light-emitting diodes 430 includes first light-emitting diodes 431 and second light-emitting diodes 432. The first light-emitting diode 431 is a pure white light-emitting diode having a color temperature of 5000 K, and the second light-emitting diode 432 is a red light-emitting diode. The first light-emitting diodes 431 and the second light-emitting diodes 432 are alternately disposed. The guide member 460 is provided over the printed circuit board 410 and serves to support the light-emitting diode color conversion filter 470 and move the position of the light-emitting diode color conversion filter 470 in a sliding manner. The guide member 460 comprises guide sidewalls 461 and a guide groove 462 formed on the inner surface of each of the guide sidewalls 461 to provide a space into which the light-emitting diode color conversion filter 470 is to be inserted. The light-emitting diode color conversion filter 470 comprises color filter regions 471 and transmission regions 472, which are alternately disposed. The light-emitting diode color conversion filter 470 is inserted into the guide grooves 462 of the guide member 460 and can be moved, as needed, to change the position of the color filter regions 471. In other words, if pure white light having a color temperature of 5000 K is needed, as shown in FIG. 15, the light-emitting diode color conversion filter 470 is moved so that the transmission regions 472 are positioned above the first light-emitting diodes 431.

Meanwhile, if natural white light having a color temperature of 4200 K is needed, as shown in FIG. 16, the light-emitting diode color conversion filter 470 is moved so that the color filter regions 471 are positioned above the first light-emitting diodes 431, after which the first light-emitting diodes are operated. In addition, if warm-white light having a color temperature of 3000 K is needed, the second light-emitting diodes 472 are additionally operated. According to this embodiment, three different color temperatures can be simply achieved.

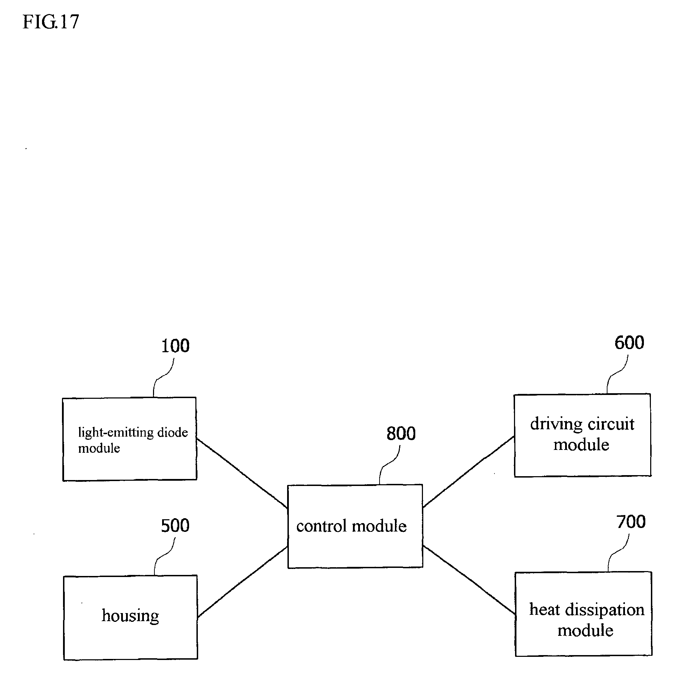

FIG. 17 is a functional block diagram of a light-emitting diode lighting device comprising the light-emitting diode module according to the present invention. Referring to FIG. 17, the light-emitting diode lighting device according to the present invention comprises a light-emitting diode module 100, a housing 500, a driving circuit module 600 and a heat dissipation module 700. The housing 500 conforms the shape of
the light-emitting diode module 100 and provides a space to receive the LED unit 1000. The driving circuit module 600 functions to receive commercial power, transform the received power to a driving voltage for driving the light-emitting diode module 100 and output the voltage. The heat-dissipation module functions to dissipate heat, generated in the light-emitting diode module 100, to the outside.

Hereinafter, a method for preparing the light-emitting diode color conversion filter according to another aspect of the present invention will be described.

### 1. Preparation of light-emitting diode color conversion filter

### Sixth embodiment

2 g of a photopolymerization initiator was added to and mixed with 398 g of an urethane acrylate oligomer having 10 acrylate functional groups to make a photopolymerizable composition. The a photopolymerizable composition was applied to a glass plate and was irradiated with 1000 mJ/cm² of UV to cure the composition. Then, the glass plate having the cured composition applied thereto was allowed to stand in an oven at 100 °C to remove unreacted material. Then, the surface of the cured composition was covered with a glass plate and heat-treated at about 150 °C. After completion of heat-treatment, the composition was cooled at room temperature, thereby preparing color filter 1.

Herein, the urethane acrylate oligomer (see the following structural formula) having 10 acrylate functional groups is characterized in that a diisocyanate group is bonded to both ends of a diester diol to form an urethane compound and the hydroxyl group of acrylate is bonded to isocyanate groups at both ends of the urethane compound. Herein, the diester diol is composed of a neopentyl glycol bonded to carboxyl groups at both ends of adipic acid, the diisocyanate is hexane diisocyanate, and the acrylate is dipentaerythritol pentaacrylate.

### Seventh embodiment

Color filter 2 was prepared in the same manner as described in Example 1, except that the composition was irradiated with 2000 mJ/cm² of UV light.

### Eighth embodiment

Color filter 3 was prepared in the same manner as described in Example 1, except that the composition was irradiated with 3000 mJ/cm² of UV light.

### Ninth embodiment

Color filter 4 was prepared in the same manner as described in Example 1, except that the composition was irradiated with 4000 mJ/cm² of UV light.

### 2. Spectral characteristics of light-emitting diode color conversion filter

In order to examine the spectral characteristics of the light-emitting diode color conversion filters prepared in the sixth to tenth embodiments, the UV/Vis transmission spectrum distribution of the light-emitting diode color conversion filters was measured by a spectrophotometer.

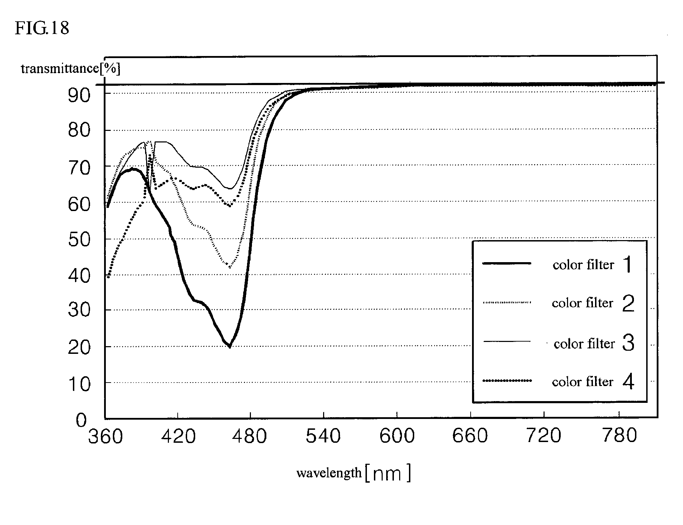

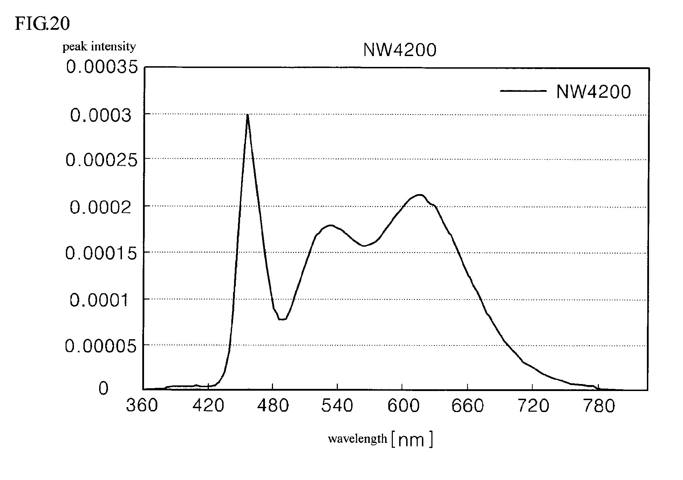

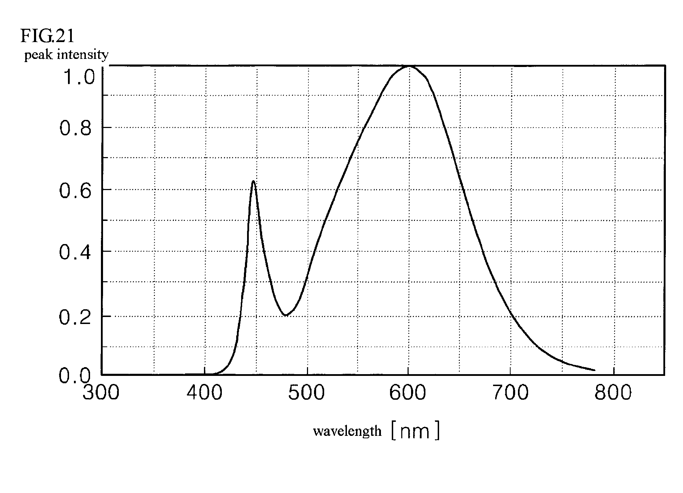

As can be seen in FIGS. 18 to 21, the light-emitting diode color conversion filter according to the present invention transmitted blue light having a wavelength of 500 nm or more and specifically blocked light having a wavelength shorter than 500 nm. Particularly, it most effectively blocked light in the wavelength range of 460-480 nm. In addition, as the amount of UV light irradiated increased, the effect of blocking light having a wavelength of less than 500 nm showed a tendency to decrease.

### Light-emitting diode lighting module

In another aspect, the present invention is directed to a light-emitting diode (LED) module comprising the light-emitting diode color conversion filter of the present invention.

Hereinafter, the light-emitting diode module according to the present invention will be described in further detail with reference to the accompanying drawings.

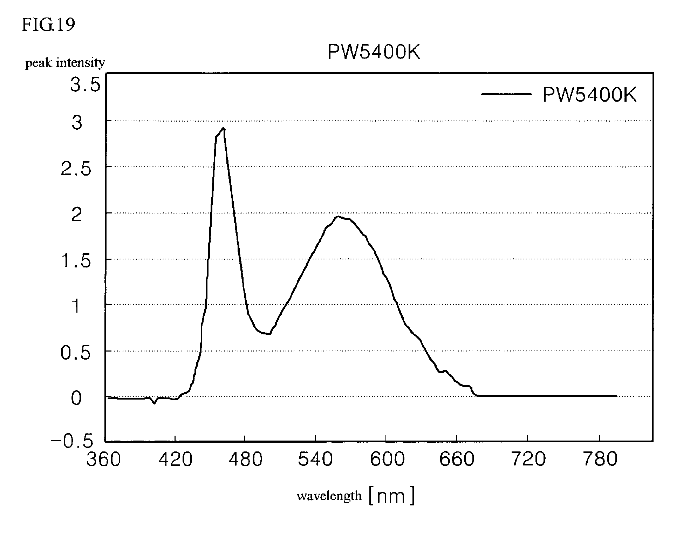

As shown in FIGS. 19 to 21, pure white light shows a strong spectral peak in the wavelength range of 440-500 nm, whereas warm-white light shows a strong spectral peak in the wavelength range longer than 500 nm, and natural white light shows spectral characteristics intermediate between those of pure white light and warm-white light.

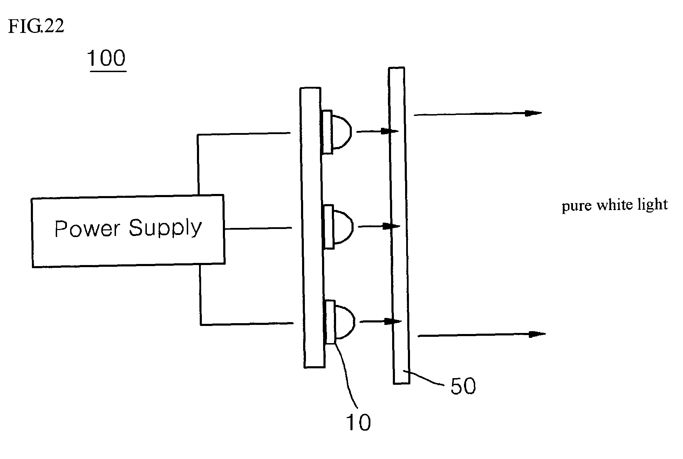

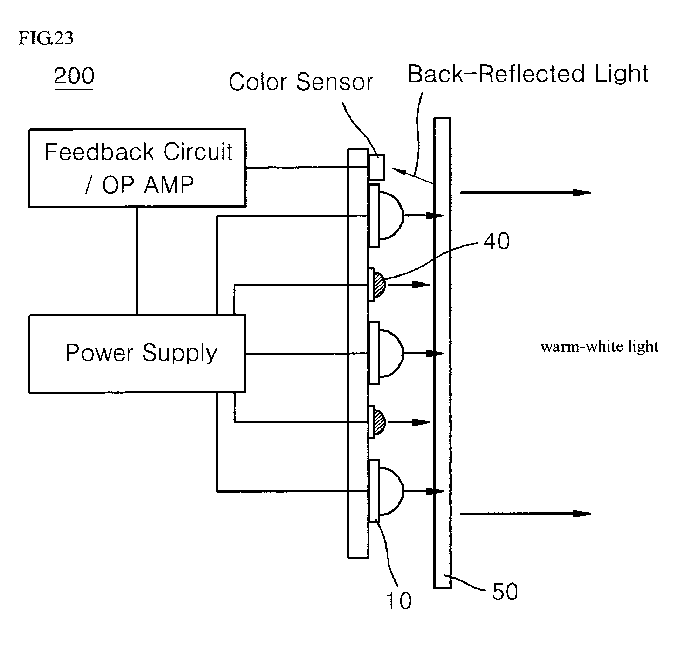

FIG. 22 shows the configuration of a light-emitting diode module according to a tenth embodiment of the present invention; and FIG. 23 shows the spectral distribution of light in a process in which pure white light emitted from the light source unit is converted to natural white light by the light-emitting diode module shown in FIG. 22. As shown in FIG. 22, a light-emitting diode module 100 comprises: a light source unit comprising one or more pure white LEDs 10 that emit pure white light having a color temperature ranging from 5000 K to 8000 K; and a light-emitting diode color conversion filter 50 according to the present invention, which serves to convert the color of light by blocking a portion of the wavelength range of the light emitted from the pure white LEDs. When the light-emitting diode color conversion filter prepared in the seventh embodiment is used as a light-emitting diode color conversion filter for the light-emitting diode module according to the tenth embodiment of the present invention, as shown in FIG. 23, the pure white light emitted from the pure white LED is converted to natural white light by the light-emitting diode color conversion filter.

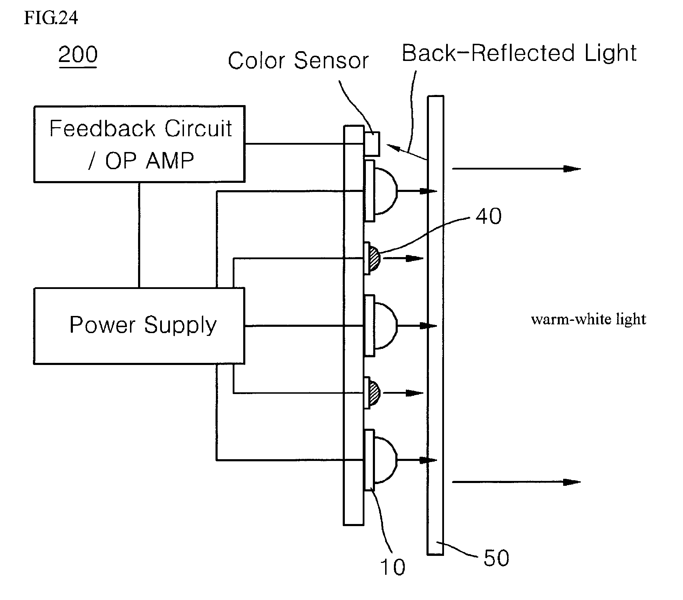

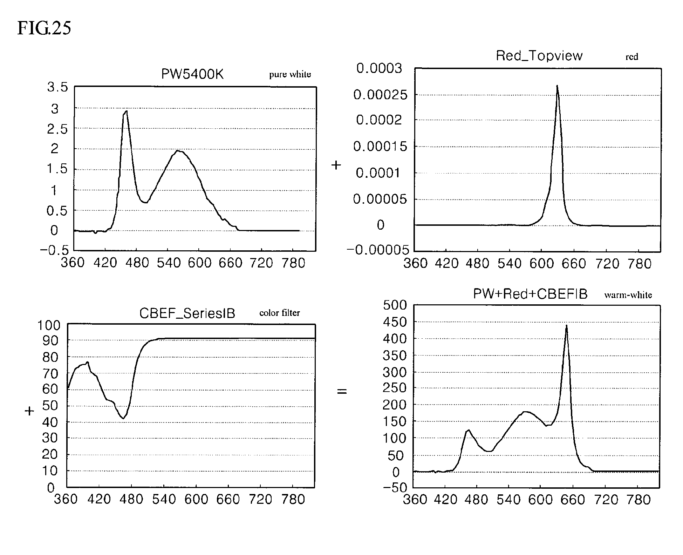

FIG. 24 shows the configuration of a light-emitting diode module according to an eleventh embodiment of the present invention; and FIG. 25 shows the spectral distribution of light in a process in which the pure white light and red light emitted from the light source unit are converted to warm-white light by the light-emitting diode module shown in FIG. 24. As shown in FIG. 24, the light-emitting diode module 200 according to the present invention comprises: a light source unit comprising one or more pure white LEDs 10 that emit pure white light having a color temperature ranging from 5000 K to 8000 K, and one or more red LEDs 40 disposed alternately with the pure white LEDs; and a light-emitting diode color conversion filter 50 according to the present invention, which serves to convert the color of light by blocking a portion of the wavelength range of the light emitted from the pure white LEDs. Herein, the red light emitted from the red LEDs preferably has a spectral peak in the wavelength range of 610-680 nm. Also, the emission of light from the red LEDs is preferably controlled by driving current. When the light-emitting diode color conversion filter prepared in the seventh embodiment is used as a light-emitting diode color conversion filter for the light-emitting diode module according to the eleventh embodiment of the present invention, as shown in FIG. 25, the pure white light and red light emitted from the light source unit are converted to natural white light by the light-emitting diode color conversion filter.

The light-emitting diode module shown in FIG. 24 emits light having a wide range of color temperature by using only pure white LEDs and red LEDs instead of using all pure white LEDs, natural white LEDs and warm-white LEDs. To emit pure white light from the light-emitting diode module shown in FIG. 24, the light emitted from the pure white LEDs is transmitted directly to a lighting region without passing through the light-emitting diode color conversion filter. In this case, the red LED is not operated. Meanwhile, to emit natural white light from the light-emitting diode module shown in FIG. 24, the pure white light emitted from the pure white LED is transmitted to the lighting region through the light-emitting diode color conversion filter. In this case, the color of the natural white light can be controlled by blocking the emission of red light from the red LED or controlling the emission of light from the red LED by driving current. In addition, to emit warm-white light from the light-emitting diode module shown in FIG. 24, the pure white light emitted from the pure white LED and the red light emitted from the red LED are transmitted to the lighting region through the light-emitting diode color conversion filter. In this case, the color of the warm-white light can be controlled by controlling the emission of light from the red LED by driving current. More specifically, a suitable color temperature is achieved by increasing or reducing the driving current of the red LED based on the results obtained by detecting the color signal of the emitted light from a color sensor circuit consisting of one or more photosensors, amplifying the signal through an OP Amp, and comparing the amplified signal value with a value corresponding to standard warm-white color.

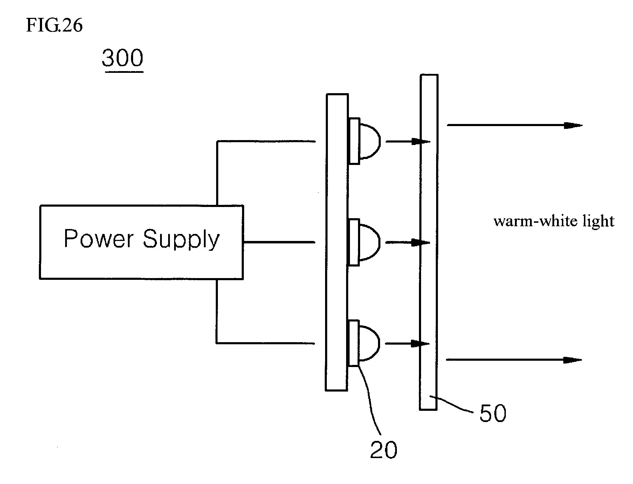

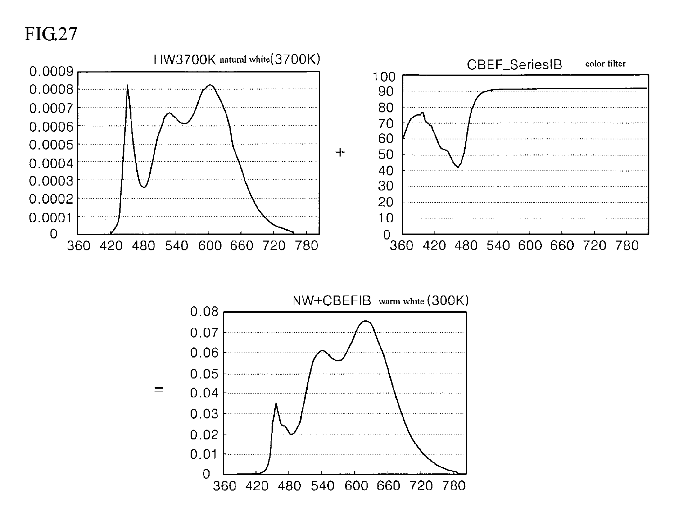

FIG. 26 shows the configuration of a light-emitting diode module according to a twelfth embodiment of the present invention; and FIG. 27 shows the spectral distribution of light in a process in which the natural white light emitted from the light source unit is converted to warm-white light by the light-emitting diode module shown in FIG. 26. As shown in FIG. 26, a light-emitting diode module 300 according to the present invention comprises: a light source unit comprising one or more natural white LEDs 20 that emits natural white light having a color temperature ranging from 3500 K to 4500 K; and a light-emitting diode color conversion filter 50 according to the present invention, which serves to convert the color of light by blocking a portion of the wavelength range of the light emitted from the natural white LEDs. When the light-emitting diode color conversion filter prepared in the seventh embodiment is used as a light-emitting diode color conversion filter for the light-emitting diode module according to the twelfth embodiment of the present invention, as shown in FIG. 27, the natural white light emitted from the natural white LED is converted to warm-white light by the light-emitting diode color conversion filter. More specifically, among the light emitted from the natural white LED, having a wavelength of 500 nm or less is blocked by the light-emitting diode color conversion filter so that it decreases to a suitable level, and light in the green wavelength range and the red wavelength range becomes relatively more intense, and thus warm-white light is obtained. Thus, the light-emitting diode module shown in FIG. 26 can emit warm-white light while maintaining the highest power efficiency.

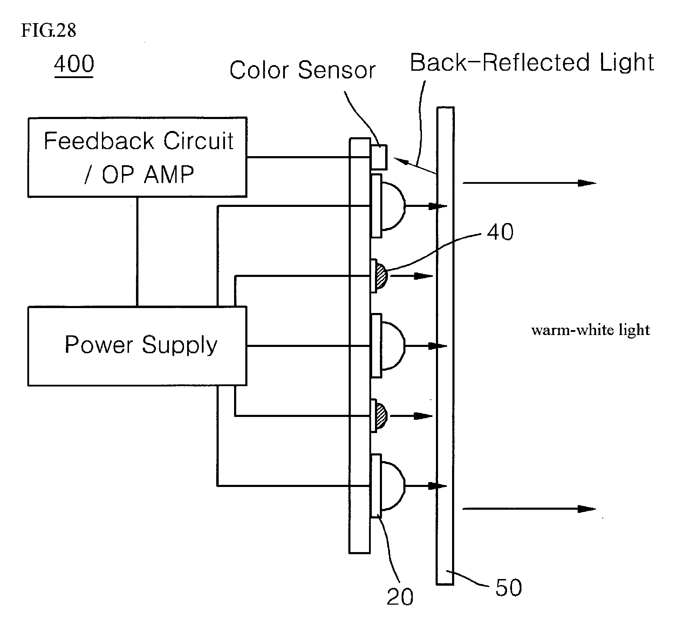

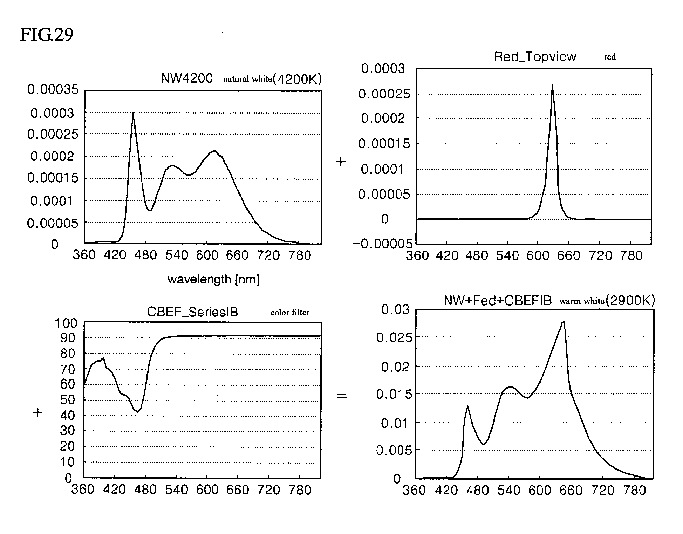

FIG. 28 shows the configuration of a light-emitting diode module according to a thirteen embodiment of the present invention; and FIG. 29 shows the spectral distribution of light in a process in which the pure white light and red light emitted from the light source unit is converted to warm-white light by the light-emitting diode module shown in FIG. 28. As shown in FIG. 28, a light-emitting diode module 400 according to the present invention comprises a light source unit comprising one or more natural white LEDs 20 that emit natural white light having a color temperature ranging from 3500 K to 4500 K, and one or more red LEDs disposed alternately with the natural white LEDs; and a light-emitting diode color conversion filter 50 according to the present invention, which serves to convert the color of light by blocking a portion of the wavelength range of the light emitted from the natural white LEDs. Herein, the red light emitted from the red LED preferably has a spectral peak in the wavelength range of 610-680 nm. The light-emitting diode module shown in FIG. 28 is configured such that when the natural white light emitted from the natural white LED is difficult to convert to warm-white light due to lack of the amount of red light, red light is supplemented so that the natural white light can be easily converted to warm-white light. Herein, the emission of light from the red LEDs is preferably controlled by driving current. When the light-emitting diode color conversion filter prepared in the seventh embodiment is used as a light-emitting diode color conversion filter for the light-emitting diode module according to the thirteen embodiment of the present invention, as shown in FIG. 29, the natural white light and red light emitted from the light source unit are converted to warm-white light by the light-emitting diode color conversion filter.

The foregoing is merely illustrative of the light-emitting diode color conversion filter according to the present invention, and a light-emitting diode module comprising the color conversion filter, and the scope of the present invention is not limited to the above-described embodiments. Those skilled in the art will appreciate that various modifications, additions and substitutions are possible, without departing from the scope and spirit of the invention as disclosed in the accompanying claims.

## Claims

1. A light-emitting diode color conversion filter having a slope of light transmittance of 0.2-0.7 in the wavelength range of 420-500 nm for light emitted from a light-emitting diode.

2. The light-emitting diode color conversion filter of claim 1, wherein the color conversion filter is made of a material comprising 0.0001-0.06 wt% of a dye or pigment that absorbs light having a wavelength of 500 nm or less, or a balance of a thermosetting or photocurable resin or a thermoplastic resin.

3. The light-emitting diode color conversion filter of claim 2, wherein the dye is any one selected from among acetate dyes, anthraquinone-based dyes and azo-based dyes, and the pigment is any one selected from among inorganic pigments, including lead chromate, iron oxide yellow, cadmium and titanium pigments, azo-based pigments and phthalocyanine pigments.

4. The light-emitting diode color conversion filter of claim 2, wherein the thermosetting resin is acrylate or epoxy resin, and the thermoplastic resin is polycarbonate or polymethylmethacrylate (PMMA).

5. A light-emitting diode module comprising: a plurality of light-emitting diodes mounted on a printed circuit board so as to be spaced from each other; and the light-emitting diode color conversion filter of claim 1, wherein the plurality of light-emitting diodes include a first light-emitting diode having a color temperature corresponding to any coordinates located in a region defined by the following six coordinates of the CIE 1931 standard colorimetric system, and a second light-emitting diode that emits red light: (0.28, 0.28), (0.40, 0.33), (0.42, 0.36), (0.44, 0.42), (0.36, 0.43), and (0.28, 0.34).

6. The light-emitting diode module of claim 5, wherein the light-emitting diode color conversion filter is composed of a transmission region and a color filter region.

7. The light-emitting diode module of claim 6, wherein the color filter region of the light-emitting diode color conversion filter is positioned above the first light-emitting diode, and the transmission region is positioned above the second light-emitting diode.

8. The light-emitting diode module of claim 7, wherein the first light-emitting diode and the second light-emitting diode are alternately disposed.

9. The light-emitting diode module of claim 5, wherein the light-emitting diode module further comprises a support member disposed on the printed circuit board and serving to support the light-emitting diode color conversion filter so as to be spaced from the light-emitting diodes.

10. The light-emitting diode module of claim 5, wherein the light-emitting diode module further comprises a guide member disposed on the printed circuit board and serving to support the light-emitting diode color conversion filter while allowing the color conversion filter to be moved in a sliding manner.

11. The light-emitting diode module of claim 5, wherein the light-emitting diode module further comprises a control unit serving to control the ON/OFF operation of each of the first light-emitting diode and the second light-emitting diode.

12. The light-emitting diode module of claim 5, wherein the control unit serves to control the emission of light from each of the light-emitting diodes by controlling the amount of current that is supplied to each of the light-emitting diodes.

13. The light-emitting diode module of claim 5, wherein the light-emitting diode light conversion filter is integrated with a light diffusion plate or a light diffusion pattern by coating or bonding.

14. A method for preparing a light-emitting diode color conversion filter, the method comprising the steps of: (a) irradiating a photopolymerizable composition, comprising 97-99.8 wt% of an urethane acrylate oligomer and 0.2-3 wt% of a photopolymerization initiator, with 500-5000 mJ/cm² of UV light to cure the composition; and (b) heat-treating the cured composition, wherein the urethane acrylate oligomer has an urethane bond in the main chain an contains 2-12 acrylate functional groups.

15. The method of claim 14, wherein the heat-treating of step (b) comprises the steps of: primarily heat-treating the cured composition at 80∼120 °C; and secondarily heat-treating the cured composition at 140∼160 °C.

16. The method of claim 15, wherein the step of secondarily heat-treating the cured composition is performed in a state in which the cured composition is fixed between two glass sheets.

17. The method of claim 15, wherein the urethane acrylate oligomer is a compound in which an acrylate having a hydroxyl group is bonded to an urethane compound composed of a diisocyanate bonded to a polyol.

18. The method of claim 17, wherein the urethane acrylate oligomer is a compound in which the hydroxyl group of acrylate is bonded to isocyanate groups at both ends of an urethane compound composed of two diisocyanates bounded to one polyol.

19. The method of claim 17, wherein the diisocyanate is at least one compound selected from the group consisting of toluene diisocyanate, xylene diisocyanate, methylene diisocyanate, tetramethylxylene diisocyanate, hexane diisocyanate, isophorone diisocyanate, and cyclohexylmethylene diisocyanate.

20. The method of claim 17, wherein the polyol is polyester polyol.

21. The method of claim 17, wherein the acrylate having the hydroxyl group is at least one compound selected from the group consisting of 2-hydroxyethyl acrylate, 2-hydroxyethyl methacrylate, ethylene glycol monomethyl ether acrylate, ethylene glycol monoethyl ether acrylate, ethylene glycol monoethyl ether methacrylate, glycerol methacrylate, ethylene glycol diacrylate, ethylene glycol dimethacrylate, diethylene glycol diacrylate, triethylene glycol diacrylate, triethylene glycol dimethacrylate, tetraethylene glycol diacrylate, tetraethylene glycol dimethacrylate, butylene glycol dimethacrylate, propylene glycol diacrylate, propylene glycol dimethacrylate, trimethylol propane triacrylate, trimethylolpropane trimethacrylate, tetramethylolpropane tetraacrylate, tetramethylolpropane tetramethacrylate, pentaerythritol triacrylate, pentaerythritol trimethacrylate, pentaerythritol tetraacrylate (DPTA), pentaerythritol tetramethacrylate, dipentaerythritol pentaacrylate, dipentaerythritol pentamethacrylate, dipentaerythritol hexaacrylate (DPHA), dipentaerythritol hexamethacrylate, 1,6-hexanediol acrylate, and 1,6-hexanediol dimethacylate.

22. The method of claim 17, wherein the photopolymerization initiator is a cationic photoinitiator or a radical photoinitiator.

23. A light-emitting diode color conversion filter which is prepared by the method of claim 14 and blocks light having a wavelength shorter than 500 nm.

24. A light-emitting diode module comprising: a light source unit comprising one or more pure white LEDs that emit pure white color having a color temperature ranging from 5000 K to 8000 K; and a light-emitting diode conversion filter configured to block a portion of the wavelength range of light emitted from the pure white LEDs to convert the color of the light.
